# FASCICULE DE BREVET EUROPEEN

(11) **EP 2 255 029 B1**
(45) Date de publication et mention de la délivrance du brevet: **02.04.2014**
(21) Numéro de dépôt: 09728134.9
(22) Date de dépôt: 19.03.2009
(51) Int. Cl.: B82Y 10/00, B82Y 30/00, C30B 25/18, C30B 29/04, C30B 29/06, C30B 29/08, C30B 29/36, C30B 29/38, C30B 29/52, C30B 29/60, H01L 31/0352

(54) **PROCEDE DE PRODUCTION DE NANOSTRUCTURES SUR UN SUBSTRAT D'OXYDE METALLIQUE ET DISPOSITIF FORME DE COUCHES MINCES**
VERFAHREN ZUR HERSTELLUNG VON NANOSTRUKTUREN AUF METALLOXIDSUBSTRAT UND DÜNNFILMVORRICHTUNG
METHOD FOR PRODUCING NANOSTRUCTURES ON METAL OXIDE SUBSTRATE AND THIN FILM DEVICE

(30) Priorité: 20.03.2008 FR 0851817
(43) Date de publication de la demande: 01.12.2010
(73) Titulaire: Ecole Polytechnique, 91120 Palaiseau (FR); Centre National de la Recherche Scientifique, 75794 Paris Cedex 16 (FR); Commissariat A L'Energie Atomique, 75015 Paris (FR)
(72) Inventeur: ALET, Pierre-Jean, Oxford OX4 3AB (GB); ROCA I CABAROCCAS, Pere, F-91140 Villebon Sur Yvette (FR)
(74) Mandataire: Michelet, Alain
(86) Numéro de dépôt international: PCT/FR2009/050470
(87) Numéro de publication internationale: WO 2009/122113

(56) Documents cités:
- GRAHAM U M ET AL: "NANOWEB FORMATION: 2D SELF-ASSEMBLY OF SEMICONDUCTOR GALLIUM OXIDE NANOWIRES/NANOTUBES" ADVANCED FUNCTIONAL MATERIALS, WILEY VCH, WIENHEIM, DE, vol. 13, no. 7, 1 juillet 2003 (2003-07-01), pages 576-581, XP001164642 ISSN: 1616-301X
- WANG Y H ET AL: "Macroscopic field emission properties of aligned carbon nanotubes array and randomly oriented carbon nanotubes layer" THIN SOLID FILMS, ELSEVIER-SEQUOIA S.A. LAUSANNE, CH, vol. 405, no. 1-2, 22 février 2002 (2002-02-22), pages 243-247, XP004342272 ISSN: 0040-6090
- SUNKARA M K ET AL: "Bulk synthesis of silicon nanowires using a low-temperature vapor-liquid-solid method" APPLIED PHYSICS LETTERS, AIP, AMERICAN INSTITUTE OF PHYSICS, MELVILLE, NY, vol. 79, no. 10, 3 septembre 2001 (2001-09-03), pages 1546-1548, XP012028827 ISSN: 0003-6951

## Description

L'invention concerne un procédé de production de nanostructures sur un substrat d'oxyde métallique, un procédé de croissance de couches minces sur un tel substrat, et un dispositif formé de couches minces.

Les nanostructures quasi monodimensionnelles, telles que les nanotubes de carbone ou les nanofils semi-conducteurs, sont particulièrement utilisées dans le domaine de l'électronique (transistors en couches minces, par exemple), dans le domaine de l'optoélectronique (cellules solaires, diodes électroluminescentes, par exemple) et comme capteurs en raison de leurs propriétés originales (optiques, électroniques, thermiques, mécaniques) et de leur grande surface spécifique.

Ces nanostructures sont obtenues par croissance ou dépôt sur un substrat, qui dans le domaine de l'optoélectronique, est préférentiellement à la fois transparent et conducteur électrique. Un tel substrat peut être obtenu en appliquant une couche mince d'oxyde métallique, comme par exemple de dioxyde d'étain (SnO₂) ou d'oxyde d'indium dopé à l'étain (ITO « Indium Tin Oxide »), sur un substrat en verre, en matériau polymère ou autre. Dans la suite de la description, un tel substrat sera appelé « substrat d'oxyde métallique ».

La plupart des nanostructures dont il est fait état, dans l'art antérieur, de la croissance directe sur ces substrats d'oxyde métalliques, sont formées d'oxydes métalliques.

Les nanostructures formées à partir d'autres semi-conducteurs (silicium, germanium, arséniure de gallium) ou de carbone croissent quant à elles sur des substrats monocristallins de silicium dans la plupart des cas, et sont éventuellement transférées par la suite vers un autre substrat.

Les procédés de production de nanostructures de l'art antérieur comprennent classiquement une première étape de formation d'agrégats métalliques sur le substrat, qui servent à catalyser la croissance des nanostructures.

On connaît différentes méthodes pour positionner des particules de catalyseur (ou agrégats métalliques) sur un substrat, telles la méthode de lithographie, l'utilisation de membranes poreuses, le dépôt de colloïdes métalliques, ainsi que l'évaporation et recuit d'une fine couche métallique.

Ces méthodes de production de nanostructures sur substrat requièrent pour la plupart des équipements lourds, et ne peuvent pas être appliquées sur de grandes surfaces. Ils ne peuvent pas être réalisées *in situ* non plus, mis à part pour la méthode d'évaporation de la couche métallique, qui nécessite en revanche une installation complexe.

Une fois que les agrégats métalliques ou catalyseurs sont formés sur le substrat, ce dernier est transféré vers un réacteur en vue d'effectuer une seconde étape qui est l'étape de croissance des nanostructures. Ce transfert entraîne une pollution ou une oxydation des catalyseurs en contact avec l'air, ainsi qu'une perte de temps (opérations de chargement/déchargement, pompages, etc...).

Lors de cette seconde étape, la croissance des nanostructures est réalisée en phase vapeur suivant le mécanisme vapeur-liquide-solide (VLS), connu du document (Wagner, R. S. & Ellis, W. C. « Vapor-liquid-solid mechanism of single crystal growth », Applied Physics Letters, 1964, 4, 89-90), ou vapeur-solide-solide (VSS), connu du document (Arbiol, J.; Kalache, B.; Roca i Cabarrocas, P.; Ramon Morante, J. & Fontcuberta i Morral, A. « Influence of Cu as a catalyst on the properties of silicon nanowires synthesized by the vapour-solid-solid mechanism » Nanotechnology, 2007, 18, 305606). La croissance des nanostructures est généralement réalisée à partir de précurseurs gazeux par la méthode de dépôt chimique en phase vapeur (CVD). La croissance des nanostructures est catalysée par les agrégats métalliques.

La plupart des procédés connus utilisent des substrats monocristallins (généralement le silicium), afin d'obtenir une croissance épitaxiale.

On connaît également de l'art antérieur un procédé de croissance par la méthode de dépôt CVD sur oxydes métalliques pour des nanotubes de carbone (Miller, A. J.; Hatton, R. A.; Chen, G. Y. & Silva, S. R. P. « Carbon nanotubes grown on In203: Sn glass as large area electrodes for organic photovoltaics », Applied Physics Letters, AIP, 2007, 90, 023105).

U. Graham et al. dans Adv. Funct. Mater. 13 (2003) p 576-581 décrit l'obtention d'une structure de nanofils ou de nanotubes en oxyde de gallium en utilisant la dissolution du gallium à la surface du substrat. Y. Wang et al. dans Thin Solid Films 405 (2002) 243-247 montre la croissance de nanotubes de carbone sur un substrat comprenant de l'oxyde de fer avant un traitement plasma réducteur.

Concernant les nanofils semi-conducteurs, le catalyseur le plus connu pour la croissance de ces nanofils est l'or, comme divulgué dans le document FR 2 873 492, avec lequel la température est généralement supérieure à 500 °C. L'utilisation de l'or comme catalyseur entraîne des défauts électroniques dans le silicium.

D'autres métaux, qui présentent tous des inconvénients, ont également été essayés comme; par exemple, le cuivre, avec lequel la fenêtre de température pour la croissance de nanofils est comprise entre 600 et 650 °C, l'aluminium, qui s'oxyde très rapidement et qui requiert donc un transfert des échantillons sous ultra-vide, et le nickel, avec lequel la croissance de nanotubes de carbone est possible à partir de 600 °C mais très lente en dessous de 700 °C.

Aucune méthode connue ne permet de faire croître des nanostructures d'un élément chimique comme le silicium directement sur un substrat d'oxyde métallique.

Un des objectifs de la présente invention est donc de proposer un procédé de production de nanostructures sur un substrat d'oxyde métallique, permettant de faire pousser ces nanostructures directement sur le substrat d'oxyde métallique, sans utilisation de catalyseur additionnel.

A cet effet, l'invention concerne un procédé de production de nanostructures sur un substrat d'oxyde métallique comme décrit dans la revendication 1.

Ce procédé, selon l'invention, permet d'éliminer une étape dans la croissance de nanostructures sur substrat, c'est-à-dire celle du dépôt et du positionnement d'agrégats d'un catalyseur métallique sur un substrat d'oxyde métallique. Les agrégats métalliques sont obtenus directement à partir de l'oxyde métallique du substrat. Cela présente l'avantage d'éviter toute pollution et oxydation des agrégats par l'air lors du transfert du substrat du dispositif où les agrégats sont positionnés, vers le réacteur dans lequel croissent les nanostructures.

En conséquence, le procédé complet de croissance est plus court, mieux contrôlé (absence de pollution) et nécessite un équipement réduit (l'usage d'un évaporateur est par exemple évité).

De plus, avec ce procédé, il est possible d'obtenir sur un substrat d'oxyde métallique, des nanostructures de nature différente de celle du substrat d'oxyde métallique.

Les éléments constituant les nanostructures proviennent du ou des gaz précurseurs.

Dans différents modes de réalisation possibles, la présente invention concerne également les caractéristiques suivantes qui pourront être considérées isolément ou selon toutes leurs combinaisons techniquement possibles et apportent chacune des avantages spécifiques :
- pendant lesdites étapes de formation des agrégats métalliques a) et de croissance de nanostructures b), le substrat d'oxyde métallique est chauffé à une température supérieure ou égale au point de fusion du métal composant l'oxyde métallique du substrat,
- l'oxyde métallique est choisi par exemple parmi le SnO₂, le ZnO, l'ITO, ou l'In₂O₃,
- le substrat d'oxyde métallique étant formé d'un substrat recouvert d'une couche d'oxyde métallique, ladite couche d'oxyde métallique est discontinue et comprend des motifs d'oxyde métallique,
- les nanostructures sont choisies parmi le Si, Ge, SiGe, SiC, C ou SiN,
- le réacteur plasma étant un réacteur de dépôt chimique en phase vapeur assisté par plasma (PECVD), le gaz précurseur, utilisé lors de l'étape de croissance des nanostructures en phase vapeur b), est dilué dans un gaz de dilution, ledit gaz de dilution favorisant la croissance de nanostructures complètement cristallines sur les agrégats métalliques, et limitant par gravure le dépôt d'éléments amorphes en dehors des agrégats métalliques,
- le gaz de dilution est le dihydrogène (H₂),
- le plasma réducteur est un plasma d'hydrogène, le procédé de traitement par plasma d'hydrogène comprenant les étapes :
   - d'injection d'hydrogène gazeux (H₂) dans l'enceinte du réacteur plasma, et
   - de génération d'un plasma dans l'enceinte du réacteur plasma pendant une durée t, le diamètre des gouttelettes d'agrégats métalliques dépendant, entre autre, de ladite durée t,
- le réacteur plasma est un réacteur de dépôt chimique en phase vapeur assistée par plasma radiofréquence (PECVD-RF), lors de l'opération de traitement par plasma d'hydrogène :
   - la pression d'hydrogène dans l'enceinte du réacteur plasma étant comprise entre 180 mTorr et 1000 mTorr, de préférence égale à 1000 mTorr, correspondant à une durée t de génération du plasma dans l'enceinte du réacteur plasma d'environ 3 min,
   - la densité de puissance radiofréquence utilisée pour générer le plasma étant comprise entre 10 et 1000 mW/cm².

L'invention concerne également un procédé de dépôt de couches minces sur un substrat d'oxyde métallique.

Selon l'invention, ce procédé comprend :
- les étapes a) et b) du procédé de production de nanostructures sur un substrat d'oxyde métallique tel que défini précédemment, un gaz précurseur étant injecté dans le réacteur plasma, de façon à obtenir un substrat d'oxyde métallique recouvert de nanofils d'élément cristallin,
- une étape de dépôt d'une couche mince d'élément amorphe ou polycristallin pendant laquelle la température du substrat d'oxyde métallique est régulée aux alentours de 200°C, le même gaz précurseur étant injecté dans ledit réacteur plasma, de façon à permettre le recouvrement des nanofils d'élément cristallin par une couche mince d'élément amorphe ou polycristallin.

Dans différents modes de réalisation possibles, la présente invention concerne également la caractéristique suivante qui pourra être considérée isolément ou en combinaison :
- le procédé de dépôt de couches minces sur un substrat d'oxyde métallique comprend, après l'étape de dépôt de la couche mince d'élément amorphe ou polycristallin, une étape de dépôt d'une couche mince d'élément amorphe ou polycristallin ou d'une couche mince organique semi-conductrice.

L'invention concerne également un dispositif formé de couches minces.

Selon l'invention, ce dispositif a été obtenu par le procédé tel que défini précédemment, et comprend :
- un substrat d'oxyde métallique recouvert de nanofils d'élément cristallin, et
- une couche mince d'élément amorphe ou polycristallin recouvrant lesdits nanofils d'élément cristallin.

Dans différents modes de réalisation possibles, la présente invention concerne également la caractéristique suivante qui pourra être considérée isolément ou en combinaison :
- le dispositif formé de couches minces comprend une couche mince d'élément amorphe ou polycristallin, ou une couche mince organique semi-conductrice, recouvrant ladite couche mince d'élément amorphe ou polycristallin.

Le procédé, selon l'invention, permet par l'utilisation de plasmas (agissant sur la dissociation des molécules des gaz précurseurs) et de métaux, issus des oxydes métalliques, à bas point de fusion, de réduire sensiblement la température au cours du traitement (moins de 300 °C, contre plus de 450 °C avec l'or comme catalyseur dans les procédés de l'art antérieur). Cela élargit la gamme des substrats potentiellement utilisables (les oxydes métalliques peuvent être déposés en couches minces sur de nombreux types de support), et induit des coûts de fabrication réduits.

La réduction de température permet également de faire baisser la consommation électrique lors de la mise en oeuvre du procédé selon l'invention, qui est un procédé plus économique que ceux de l'art antérieur.

Les nanostructures obtenues avec ce procédé sont également de meilleure qualité. Ce procédé permet d'avoir une solidarité parfaite entre les nanostructures et le substrat d'oxyde métallique (puisqu'elles croissent directement à partir de celui-ci). Le substrat d'oxyde métallique a lui-même des propriétés électriques et optiques utilisables dans les dispositifs formés de couches minces.

Comme les traitements par plasma peuvent être appliqués sur des échantillons de grande taille (il existe des réacteurs permettant des dépôts de silicium amorphe sur des substrats de 5 m²), ce procédé permet d'obtenir rapidement des tapis de nanostructures sur de grandes surfaces.

L'invention sera décrite plus en détail en référence aux dessins annexés dans lesquels :
- la figure 1 représente un réacteur plasma dans lequel est réalisée l'étape de formation d'agrégats métalliques sur un substrat d'oxyde métallique, selon un mode de réalisation de l'invention ;
- la figure 2 représente ce même réacteur plasma lorsque le substrat d'oxyde métallique est chauffé en présence d'un gaz précurseur (p.ex. de silane), selon ce même mode de réalisation de l'invention ;
- la figure 3 représente ce même réacteur plasma lorsque la croissance des nanostructures en phase vapeur est catalysée par les agrégats métalliques, selon ce même mode de réalisation de l'invention ;
- la figure 4 représente un dispositif formé de couches minces, selon un mode de réalisation de l'invention ;
- la figure 5 représente un spectre d'absorption d'un substrat d'ITO après un traitement par plasma d'hydrogène ;
- La figure 6 représente une image de nanofils de silicium cristallin sur un substrat d'oxyde métallique, réalisée par microscopie électronique à balayage ;
- La figure 7 représente une image en microscopie électronique à balayage montrant une limite entre une zone comprenant des nanofils de silicium cristallin et une zone comprenant du silicium amorphe ;
- La figure 8 représente deux spectres Raman correspondant respectivement à la zone comprenant des nanofils de silicium cristallin et à celle comprenant du silicium amorphe.

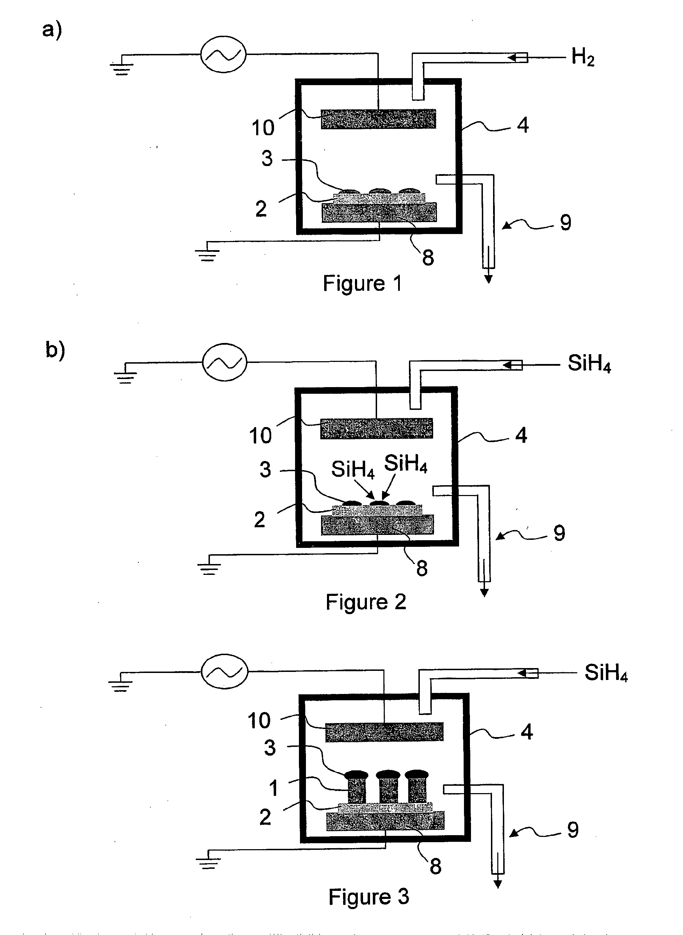

La figure 1 représente un réacteur plasma dans lequel est réalisée l'étape de formation d'agrégats métalliques sur un substrat d'oxyde métallique, selon un mode de réalisation de l'invention.

Dans cet exemple, ce réacteur plasma est un réacteur par dépôt chimique en phase vapeur assisté par plasma radio fréquence (PECVD-RF « Radio Frequency Plasma Enhanced Chemical Vapor Déposition »). Il est également possible d'utiliser d'autres types de réacteurs plasma (p.ex. VHF, micro-ondes...) et d'autres conditions opératoires.

Le substrat d'oxyde métallique 2 est composé d'un substrat en verre ou polymère ou autre recouvert d'une couche mince d'oxyde métallique.

Le dépôt de la couche d'oxyde métallique peut être obtenu par différentes techniques de dépôt comme la pyrolyse, la pulvérisation, le dépôt chimique en phase vapeur (CVD), etc...

La couche d'oxyde métallique peut être optiquement transparente ou non et présenter des propriétés optiques et conductrices.

Après un nettoyage classique du substrat d'oxyde métallique 2 (bains de solvant), ce dernier est introduit dans l'enceinte du réacteur plasma 4. Il est disposé sur un porte substrat 8.

L'enceinte du réacteur plasma 4 est ensuite pompée sous vide secondaire (typiquement, 5×10⁻⁶ mbar). Le réacteur plasma comprend une voie de pompage 9 reliée à une pompe (non représentée).

Selon l'invention, l'étape de formation d'agrégats métalliques a) comprend une opération de réduction de la surface du substrat d'oxyde métallique au moyen d'un traitement par plasma réducteur, entraînant la formation de gouttelettes d'agrégats métalliques 3 sur la surface du substrat d'oxyde métallique 2. On entend par plasma réducteur, un plasma comprenant un élément réducteur comme le dihydrogène (H₂) ou l'ammoniaque (NH₃), par exemple.

Le traitement par plasma réducteur entraîne une réduction superficielle du substrat d'oxyde métallique 2. La couche d'oxyde métallique 2 peut être entièrement réduite ou non. La réduction complète de la couche d'oxyde est toujours possible, le choix dépend du souhait de conserver ou non la fonction de la couche d'oxyde métallique.

Le substrat d'oxyde métallique 2 est composé de l'oxyde d'un métal ayant un point de fusion ou d'eutectique inférieur ou égale à 300°C, tel le dioxyde d'étain (SnO₂), l'oxyde d'indium dopé à l'étain (ITO « Indium Tin Oxide »), ou le trioxyde d'indium (In₂O₃). L'oxyde métallique peut être dopé ou non. L'utilisation d'un tel substrat permet de réduire sensiblement la température du gaz et du substrat au cours du traitement.

Le substrat d'oxyde métallique 2 peut également être composé de l'oxyde d'un métal ayant un point de fusion ou d'eutectique supérieur à 300°C.

L'exemple des figures 1 à 3 est donné pour un procédé de production de nanofils de silicium sur un substrat d'oxyde métallique 2 à base d'ITO.

Pendant les étapes de formation des agrégats métalliques a) et de croissance de nanostructures b), le substrat d'oxyde métallique 2 est chauffé à une température supérieure ou égale au point de fusion du métal composant l'oxyde métallique du substrat.

Le réacteur plasma comprend une électrode radiofréquence 10 qui est chauffée à une température typique de 200 °C. La température du gaz est donc inférieure à 300 °C.

De l'hydrogène gazeux (H₂) est introduit dans l'enceinte du réacteur plasma 4, à un débit d'environ 100 sccm (centimètre cube par minute ou « standard cubic centimeters per minute »). La vitesse de pompage est ajustée pour maintenir la pression dans l'enceinte du réacteur plasma 4 à une valeur fixe qui est comprise entre 180 mTorr et 1000 mTorr.

Par application d'un potentiel variable à l'électrode radiofréquence 10, un plasma est généré dans l'enceinte du réacteur plasma 4, avec une puissance injectée d'environ 5 W, et maintenu pendant une durée t variable qui est fonction de la pression dans l'enceinte du réacteur plasma 4. La fréquence du plasma radiofréquence est de 13,56 MHz. La puissance injectée dépend de la taille du réacteur. La densité de puissance radiofréquence utilisée pour générer le plasma est comprise entre 10 et 1000 mW/cm².

Par exemple, une pression de 1000 mTorr d'hydrogène dans l'enceinte du réacteur plasma 4 correspond à un temps recommandé de traitement par plasma réducteur de 3 min. La durée optimale du traitement dépend de la réactivité de l'oxyde vis-à-vis de l'hydrogène. Elle est plus courte avec l'ITO qu'avec le SnO₂.

Par dissociation de l'hydrogène gazeux (H₂), des ions H⁺ et des atomes d'hydrogène sont formés, puis accélérés sur le substrat d'oxyde métallique 2, induisant une réduction chimique à la surface du substrat d'oxyde métallique 2.

En réduisant au moins une partie des oxydes métalliques présents sur la surface du substrat d'oxyde métallique 2, des gouttelettes d'agrégats métalliques 3 se forment sur la surface du substrat d'oxyde métallique 2.

En faisant varier le temps ou les conditions de traitement, il est possible de modifier la quantité de métal réduit et donc la taille et la densité des gouttelettes. Le diamètre des gouttelettes d'agrégats métalliques 3, qui peut être de l'ordre du nanomètre jusqu'à plusieurs nanomètres, dépend de la durée t durant laquelle le plasma est généré. D'autres paramètres comme la puissance, la température, la pression, la réactivité de l'oxyde métallique vis-à-vis de l'hydrogène influencent la taille et la densité des gouttelettes.

Le traitement par plasma réducteur modifie très peu les propriétés optiques et électriques du substrat d'oxyde métallique 2, dans le cas d'une réduction partielle.

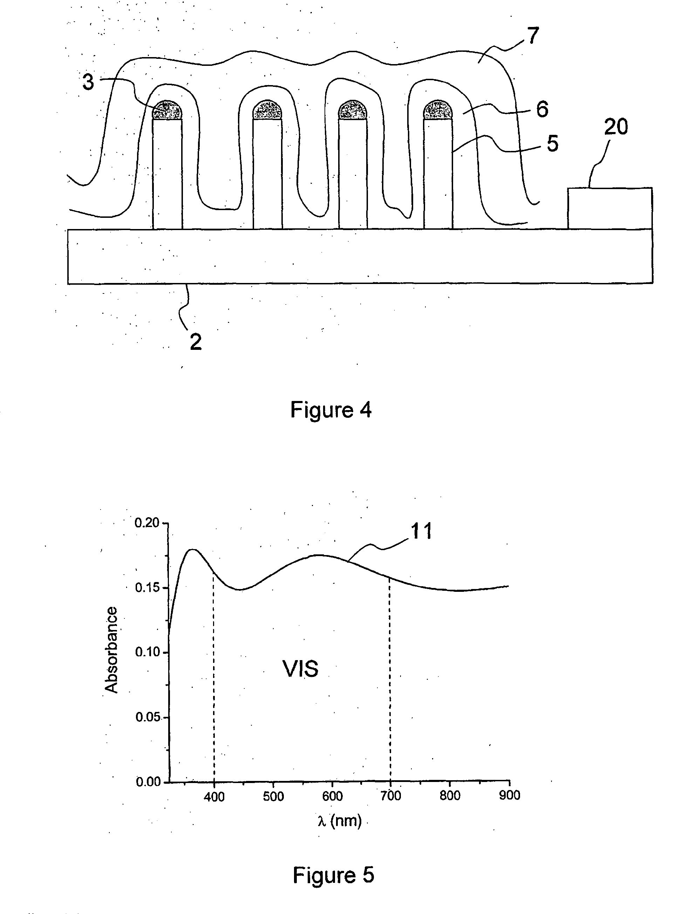

La figure 5 représente le spectre d'absorption 11 de l'ITO sur un substrat de verre après 5 min de traitement par plasma d'hydrogène à une pression de 180 mTorr.

Ce spectre d'absorption 11 montre qu'après ce traitement par plasma d'hydrogène, le substrat d'ITO reste encore largement transparent dans le domaine du visible (longueurs d'onde comprises entre environ 400 nm à 700 nm). Le niveau d'absorbance du substrat d'ITO est compris entre environ 0,15 et 0,18.

Le procédé de production de nanostructures 1 sur le substrat d'oxyde métallique 2 comprend également une étape b) de croissance de nanostructures 1 en phase vapeur sur le substrat d'oxyde métallique 2 portant les gouttelettes métalliques, comme représenté sur les figures 2 et 3.

Le substrat d'oxyde métallique 2 est chauffé en présence d'un ou plusieurs gaz précurseurs, et la croissance de nanostructures 1 en phase vapeur est catalysée par les agrégats métalliques 3. Dans l'exemple des figure 2 et 3, un seul gaz précurseur est utilisé, le silane (SiH₄), afin d'obtenir un dépôt de nanofils de silicium cristallin 5. D'autres gaz précurseurs peuvent également être utilisés comme le disilane ou le tétrafluorosilane (SiF₄) pour la fabrication de nanofils de silicium cristallin 5.

La croissance de nanofils et de nanotubes semi-conducteurs sur substrat se fait généralement selon le mécanisme vapeur-liquide-solide (VLS), dans lequel les agrégats métalliques 3 jouent un rôle déterminant. Le mécanisme vapeur-solide-solide (VSS) peut également être utilisé.

Selon le mécanisme VLS, les agrégats métalliques 3 situés à la surface du substrat d'oxyde métallique 2 peuvent, dans un premier temps, catalyser la dissociation du gaz précurseur.

Lorsque la température de croissance est située au-dessus du point d'eutectique du mélange silicium/métal, les atomes précurseurs diffusent dans l'agrégat qui devient liquide.

Lorsque la concentration dans la goutte de mélange précurseur/métal ainsi formée atteint une valeur de saturation, les atomes précurseurs précipitent.

En raison de la faible taille des gouttes de mélange précurseur/métal et de l'importance que prennent alors les énergies de surface, cette précipitation a lieu préférentiellement à une interface, généralement à l'interface entre le substrat d'oxyde métallique 2 et la goutte de mélange précurseur/métal.

Il se forme alors une phase solide, qui conduit à une croissance colonnaire sous la goutte de mélange précurseur/métal. La taille et la densité des agrégats métalliques 3 contrôlent donc celles des nanostructures 1 obtenues.

De plus, la température de croissance des nanostructures 1 est contrainte par le point d'eutectique du mélange précurseur/métal.

Or le procédé, par la réduction d'oxydes métalliques, permet d'utiliser des métaux dont le point de fusion est bas (156,6 °C pour l'indium et 231,9 °C pour l'étain, par exemple), comme a fortiori le point d'eutectique du mélange catalyseur/précurseur. La croissance des nanostructures 1 peut donc se faire à température réduite.

Un exemple de procédé de production de nanofils de silicium sur un substrat d'ITO est illustré ci-dessous. Ce procédé a aussi été testé avec succès sur un substrat de SnO₂.

Comme représenté sur la figure 2, l'arrivée d'hydrogène est coupée et le gaz précurseur SiH₄ est introduit. Il est possible d'ajouter un gaz dopant, comme la phosphine (PH₃) ou le tri-méthyle bore (B(CH₃)₃), au gaz précurseur. Aucune manipulation du substrat d'oxyde métallique 2, ouverture du réacteur plasma, ni pompage supplémentaire n'est nécessaire.

La pression de gaz précurseur SiH₄ dans l'enceinte du réacteur plasma 4 est maintenue aux alentours de 60 mTorr. Un plasma est allumé, avec une puissance injectée de 2 W et maintenu pendant une durée variable en fonction de la longueur des nanofils de silicium cristallin 5 souhaitée.

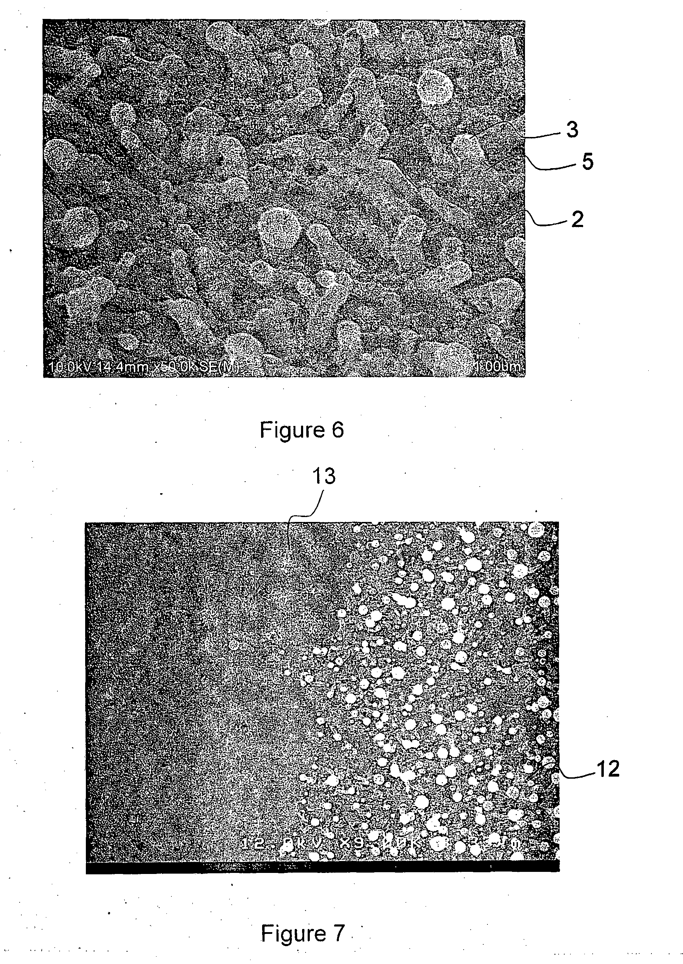

Des nanofils de silicium cristallin 5, non dopés, obtenus dans ces conditions avec un temps de croissance de 15 min sont présentés sur la figure 6. La figure 6 représente une image des nanofils de silicium cristallin 5, réalisée par microscopie électronique à balayage. L'échantillon est incliné de 45° par rapport au faisceau d'électron du microscope électronique à balayage.

La longueur typique des nanofils de silicium cristallin 5 est de 300 nm, leur diamètre de base est compris entre 50 et 200 nm. On distingue en gris clair, au bout des nanofils de silicium cristallin 5, les gouttelettes d'agrégats métalliques 3.

Le substrat d'oxyde métallique 2 est formé d'un substrat en verre ou autre, comme dit précédemment, et recouvert d'une couche d'oxyde métallique.

Selon un mode de réalisation particulier de l'invention, la couche d'oxyde métallique est discontinue et comprend des motifs ou plots d'oxyde métallique. En effet, il est possible de créer des motifs d'oxyde métallique sur le substrat de verre, par exemple, par des méthodes connues de lithographie. Il est possible, par lithographie, de définir des motifs d'oxyde métallique de petite taille (quelques nm à quelques microns) régulièrement espacés sur le substrat.

Après les étapes de formation d'agrégats métalliques a) et de croissance de nanostructures b) selon l'invention, le dispositif à couche mince obtenu comprend une ou plusieurs zones 12 comportant des nanofils de silicium cristallin et une ou plusieurs zones 13 comprenant du silicium amorphe, par exemple, comme illustré sur l'exemple de la figure 7. La figure 7 représente une image en microscopie électronique à balayage d'une limite entre une zone comprenant des nanofils de silicium cristallin 12 et une zone comprenant du silicium amorphe 13.

La zone 12 comprenant des nanofils de silicium cristallin correspond à une zone du substrat de verre initialement recouverte d'ITO. Cette zone 12 est très diffusive. Quant à la zone 13 comprenant du silicium amorphe, elle correspond à une zone du substrat de verre non recouverte d'ITO. Cette zone 13 est plus transparente que la zone 12 comprenant des nanofils de silicium cristallin. En utilisant un plot d'oxyde métallique ayant une surface de l'ordre du micromètre carré, il est possible, avec le procédé selon l'invention, de contrôler la croissance d'une unique nanostructure et donc du composant électronique réalisé par la suite. Pour les applications en électronique, il est possible de définir les zones où seront localisés les composants électroniques.

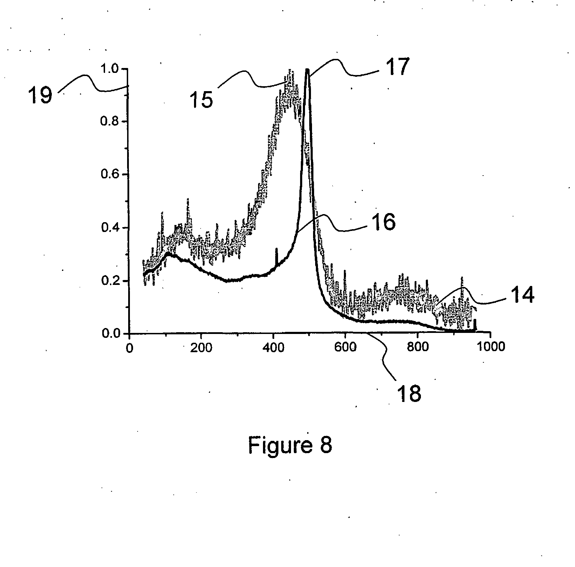

La figure 8 représente deux spectres Raman 14, 16 du dépôt de silicium sur les deux zones 12, 13 de l'échantillon présenté à la figure 7.

L'axe des abscisses 18 représente le décalage Raman en cm⁻¹. L'axe des ordonnés 19 représente l'intensité normalisée.

Le spectre Raman 14 de la zone 13 comprenant du silicium amorphe présente un pic large 15 centré à environ 480 cm⁻¹. Le spectre Raman 16 de la zone 12 comprenant des nanofils de silicium cristallin présente un pic étroit 17 centré vers 510 cm⁻¹ correspondant à du silicium cristallin.

L'exemple ci-dessus montre un exemple de réalisation permettant d'obtenir des nanofils de silicium.

Avec le procédé de production de nanostructures sur un substrat d'oxyde métallique, selon l'invention, il est possible de faire croître, sur un substrat d'oxyde métallique 2, des nanostructures 1 de nature (ou composition) différente de celle du substrat d'oxyde métallique 2.

Les gouttelettes d'agrégats métalliques 3 (en métal) étant formées à partir du substrat d'oxyde métallique 2, ces dernières sont également de nature différente de celle des nanostructures 1.

Les éléments constituant les nanostructures 1 proviennent du ou des gaz précurseurs injectés lors de l'étape b) de croissance de nanostructures. Les éléments constituant les nanostructures 1 sont non métalliques.

Il est possible d'obtenir des nanostructures 1 à base de germanium, de silicium, de gallium ou de carbone sur des substrats d'oxyde métallique 2.

Avec le procédé de production de nanostructures sur un substrat d'oxyde métallique, selon l'invention, il est possible d'obtenir, sur un substrat d'oxyde métallique 2, des nanofils de semi-conducteurs binaires, de germanium (Ge), de siliciure de germanium (SiGe), de carbure de silicium (SiC), de nitrure de silicium (SiN), d'arsénure de gallium (AsGa), ou d'autres composés.

Le procédé de production de nanostructures sur un substrat d'oxyde métallique, selon l'invention, est également utilisable pour déposer des nanotubes de carbone sur un substrat d'oxyde métallique 2. Le gaz précurseur utilisé est alors le méthane.

La croissance de nanostructures 1 en phase vapeur sur le substrat d'oxyde métallique peut être réalisée préférentiellement par la méthode PECVD, comme dit précédemment, mais également par une méthode de dépôt chimique en phase vapeur (CVD).

L'invention concerne également un procédé de dépôt de couches minces sur un substrat d'oxyde métallique 2 comprenant les étapes a) et b) du procédé de production de nanostructures 1 sur un substrat d'oxyde métallique 2, tel que défini précédemment, permettant d'obtenir un substrat d'oxyde métallique 2 recouvert de nanofils d'élément cristallin 5.

Les gaz présents, les conditions de dépôt température, pression et la puissance injectée dans le plasma peuvent être ensuite modifiés pour déposer d'autres couches minces de matériaux sur les nanostructures 1, sans sortir celles-ci à l'air.

Par exemple, en réduisant la température du substrat d'oxyde métallique 2, il est possible de déposer une couche mince d'élément amorphe ou polycristallin 6 se conformant à la morphologie des nanostructures 1, comme représenté sur la figure 4.

Le même gaz précurseur que celui utilisé dans l'étape b) de croissance de nanostructures 1 en phase vapeur sur le substrat d'oxyde métallique 2, est injecté dans le réacteur plasma 4, de façon à permettre le recouvrement des nanofils d'élément cristallin 5 par une couche mince d'élément amorphe ou polycristallin 6 constituée du même élément chimique que celui des nanofils d'élément cristallin 5, par exemple de silicium.

Lorsque l'élément chimique est le silicium, la température du substrat d'oxyde métallique 2 peut être régulée aux alentours de 200 °C.

Dans un autre mode de réalisation possible, le précurseur gazeux utilisé lors de l'étape de croissance des nanostructures 1 en phase vapeur b), peut être injecté dans le réacteur plasma 4 en dilution dans un gaz provoquant des réactions de gravure. Ce gaz de dilution peut être de l'hydrogène par exemple. Le plasma est ensuite généré. L'élément amorphe étant gravé plus facilement que l'élément cristallin, cette méthode permet de diminuer l'épaisseur de la couche d'élément amorphe déposée pendant la croissance des nanostructures 1, autour des nanofils d'élément cristallin 5. Le dépôt d'élément amorphe par la méthode PECVD, hors agrégats métalliques 3, est limité. Cette dilution dans un gaz de gravure permet de favoriser la croissance des nanofils d'élément cristallin 5 sur les agrégats métalliques 3 par rapport au dépôt parasite d'élément amorphe.

Le procédé de dépôt de couches minces sur le substrat d'oxyde métallique 2 peut également comprendre, après l'étape de dépôt de la couche mince d'élément amorphe ou polycristallin 6, une étape de dépôt d'une couche mince d'élément polycristallin ou amorphe 7 ou d'une couche mince organique semi-conductrice.

La couche mince d'élément polycristallin 7 peut être une couche mince inorganique constituée du même élément chimique que celui des nanofils d'élément cristallin 5 et de la couche mince d'élément amorphe ou polycristallin 6. Il est possible de former, par exemple, une cellule photovoltaïque en couches minces de silicium.

Les nanofils d'élément cristallin 5 peuvent servir de germe pour la croissance du silicium polycristallin.

La couche mince d'élément polycristallin 7 peut être également une couche mince inorganique constituée d'un élément chimique différent ou du même élément chimique dopé.

En utilisant une couche mince organique semi-conductrice, il est possible de former une cellule photovoltaïque hybride.

La couche très diffusive formée par les nanofils de silicium permet d'augmenter la longueur du chemin optique de la lumière incidente dans le dispositif, et donc, pour une même épaisseur donnée, d'améliorer l'absorption du rayonnement.

On obtient un dispositif formé de couches minces, tel que représenté sur la figure 4, comprenant un substrat d'oxyde métallique 2 recouvert de nanofils d'élément cristallin 5, une couche mince d'élément amorphe ou polycristallin 6 recouvrant les nanofils d'élément cristallin 5, et une autre couche mince d'élément polycristallin ou amorphe 7, ou une couche mince organique semi-conductrice, recouvrant la couche mince d'élément amorphe ou polycristallin 6.

Les échantillons obtenus après les étapes a) et b) du procédé de production de nanostructures 1 peuvent ainsi être complétés *in situ* dans le même réacteur plasma 4, par d'autres couches minces afin de former un dispositif semi-conducteur, comme par exemple une cellule photovoltaïque p-i-n ou n-i-p.

Ce dispositif formé de couches minces comprend également un contact 20 relié au substrat d'oxyde métallique 2. Les nanostructures 1 peuvent être utilisés comme texture de l'électrode.

Les différentes étapes décrites ci-dessus sont réalisées successivement dans le même réacteur plasma 4.

Le procédé de production de nanostructures 1 sur un substrat d'oxyde métallique 2 décrit ci-dessus utilise un plasma radiofréquence (R.F.), mais ce procédé n'est pas limité à ce seul type de plasma.

Comme les traitements par plasma peuvent être appliqués sur des échantillons de grande taille (il existe des réacteurs permettant des dépôts de silicium amorphe sur des substrats de 5 m²), ce procédé permet d'obtenir rapidement des tapis de nanostructures 1 sur de grandes surfaces.

Le procédé, selon l'invention, permet également d'éliminer une étape dans la croissance de nanostructures 1 sur substrat, c'est-à-dire celle du dépôt et du positionnement d'agrégats d'un catalyseur métallique. En conséquence, le procédé complet de croissance est plus court, mieux contrôlé (absence de pollution) et nécessite un équipement réduit (l'usage d'un évaporateur est par exemple évité).

Le procédé, selon l'invention, permet de plus, par l'utilisation de plasmas (agissant sur la dissociation des molécules des gaz précurseur) et de métaux, issus des oxydes métalliques, à bas point de fusion, de réduire sensiblement la température au cours du traitement (moins de 300 °C, contre plus de 450 °C avec l'or comme catalyseur pour les dispositifs de l'art antérieur). Cela élargit la gamme des substrats potentiellement utilisables (les oxydes métalliques peuvent être déposés en couches minces sur de nombreux types de support), et induit des coûts de fabrication réduits.

Ce procédé permet d'avoir une solidarité parfaite entre les nanostructures 1 et le substrat d'oxyde métallique 2 (puisqu'elles croissent directement à partir de celui-ci). Le substrat d'oxyde métallique 2 a lui-même des propriétés électriques et optiques utilisables dans les dispositifs formés de couches minces.

## Revendications

1. Procédé de production de nanostructures (1) sur un substrat d'oxyde métallique (2) comprenant les étapes de :
a) formation d'agrégats métalliques (3) sur ledit substrat d'oxyde métallique (2),
b) croissance de nanostructures (1) en phase vapeur sur ledit substrat d'oxyde métallique (2) recouvert d'agrégats métalliques (3), ledit substrat étant chauffé en présence d'un ou plusieurs gaz précurseurs, et la croissance de nanostructures (1) en phase vapeur étant catalysée par les agrégats métalliques (3),
**caractérisé en ce que** :
- le substrat d'oxyde métallique (2) est composé d'un substrat en verre ou polymère ou autre recouvert d'une couche mince d'oxyde métallique, la couche mince d'oxyde métallique étant composée de l'oxyde d'un métal ayant un point de fusion inférieur ou égal à 300°C, tel que le SnO₂, le ZnO, l'ITO, ou l'In₂O₃ ;
- l'étape de formation d'agrégats métalliques a) comprend une opération de réduction de la surface du substrat d'oxyde métallique au moyen d'un traitement par plasma réducteur, entraînant la formation de gouttelettes d'agrégats métalliques (3) sur la surface dudit substrat d'oxyde métallique (2),
- lesdites étapes de formation d'agrégats métalliques a) et de croissance de nanostructures b) sont réalisées successivement dans une même et unique enceinte de réacteur plasma (4), la croissance des nanostructures, par CVD ou par PECVD, s'effectuant directement sur les gouttelettes d'agrégats métalliques (3) ;
- le substrat d'oxyde métallique (2) étant chauffé à une température supérieure ou égale au point de fusion du métal composant l'oxyde métallique (2) pendant lesdites étapes de formation des agrégats métalliques a) et de croissance de nanostructures b) ; et **en ce que**
- les éléments constituant les nanostructures (1) proviennent du ou des gaz précurseurs injectés lors de l'étape b) de croissance de nanostructures, les éléments constituant les nanostructures (1) étant non métalliques, et
- la composition des nanostructures (1) étant différente de celle du substrat d'oxyde métallique (2).

2. Procédé de production de nanostructures (1) sur un substrat d'oxyde métallique (2) selon la revendication 1, **caractérisé en ce que** l'oxyde métallique est choisi parmi le SnO₂, le ZnO, l'ITO, ou l'In₂O₃.

3. Procédé de production de nanostructures (1) sur un substrat d'oxyde métallique (2) selon l'une quelconque des revendications 1 ou 2, **caractérisé en ce que**, le substrat d'oxyde métallique (2) étant formé d'un substrat recouvert d'une couche d'oxyde métallique, ladite couche d'oxyde métallique est discontinue et comprend des motifs d'oxyde métallique.

4. Procédé de production de nanostructures (1) sur un substrat d'oxyde métallique (2) selon l'une quelconque des revendications 1 à 3, **caractérisé en ce que** les nanostructures (1) sont choisies parmi le Si, Ge, SiGe, SiC, C ou SiN.

5. Procédé de production de nanostructures (1) sur un substrat d'oxyde métallique (2) selon l'une quelconque des revendications 1 à 4, **caractérisé en ce que**, le réacteur plasma (4) étant un réacteur de dépôt chimique en phase vapeur assisté par plasma (PECVD), le gaz précurseur utilisé lors de l'étape de croissance des nanostructures (1) en phase vapeur b), est dilué dans un gaz de dilution, ledit gaz de dilution limitant par gravure le dépôt d'éléments amorphes en dehors des agrégats métalliques (3).

6. Procédé de production de nanostructures (1) sur un substrat d'oxyde métallique (2) selon la revendication 5, **caractérisé en ce que** le gaz de dilution est le dihydrogéne (H₂).

7. Procédé de production de nanostructures (1) sur un substrat d'oxyde métallique (2) selon l'une quelconque des revendications 1 à 6, **caractérisé en ce que** le plasma réducteur est un plasma d'hydrogène, le procédé de traitement par plasma d'hydrogène comprenant les étapes :
- d'injection d'hydrogène gazeux (H₂) dans l'enceinte du réacteur plasma (4), et
- de génération d'un plasma dans l'enceinte du réacteur plasma (4) pendant une durée t, le diamètre des gouttelettes d'agrégats métalliques (3) dépendant, entre autre, de ladite durée t.

8. Procédé de production de nanostructures (1) sur un substrat d'oxyde métallique (2) selon l'une quelconque des revendications 1 à 7, **caractérisé en ce que** le réacteur plasma (4) est un réacteur de dépôt chimique en phase vapeur assisté par plasma radiofréquence (PECVD-RF), lors de l'opération de traitement par plasma d'hydrogène :
- la pression d'hydrogène dans l'enceinte du réacteur plasma (4) étant comprise entre 180 mTorr et 1000 mTorr, correspondant à une durée t de génération du plasma dans l'enceinte du réacteur plasma (4) d'environ 3 min,
- la densité de puissance radiofréquence utilisée pour générer le plasma étant comprise entre 10 et 1000 mW/cm².

9. Procédé de production de nanostructures (1) sur un substrat d'oxyde métallique (2), selon l'une quelconque des revendications 1 à 8, caractérisé en ce :
- le substrat d'oxyde métallique (2) étant recouvert de nanostructures (1) du type nanofils d'élément cristallin (5),
- le procédé comprend en outre une étape de dépôt d'une couche mince d'élément amorphe ou polycristallin pendant laquelle la température du substrat d'oxyde métallique (2) est régulée aux alentours de 200°C, le même gaz précurseur étant injecté dans ledit réacteur plasma (4), de façon à permettre le recouvrement des nanofils d'élément cristallin (5) par une couche mince d'élément amorphe ou polycristallin (6).

10. Procédé selon la revendication 9, **caractérisé en ce qu'**il comprend, après l'étape de dépôt de la couche mince d'élément amorphe ou polycristallin (6), une autre étape de dépôt d'une couche mince d'élément amorphe ou polycristallin (7) ou d'une couche mince organique semi- conductrice.

11. Dispositif formé de couches minces, **caractérisé en ce qu'**il a été obtenu par le procédé tel que défini par l'une quelconques des revendications 9 ou 10, ledit dispositif formé de couches minces comprenant:
- un substrat d'oxyde métallique (2) recouvert de nanofils d'élément cristallin (5), et
- une couche mince d'élément amorphe ou polycristallin (6) recouvrant lesdits nanofils d'élément cristallin (5).

12. Dispositif formé de couches minces selon la revendication 11, **caractérisé en ce qu'**il comprend une couche mince d'élément amorphe ou polycristallin (7), ou une couche mince organique semi-conductrice, recouvrant ladite couche mince d'élément amorphe ou polycristallin (6).

## Patentansprüche

1. Verfahren zur Herstellung von Nanostrukturen (1) auf einem Metalloxidsubstrat (2), das die folgenden Schritte umfasst:
a) Bildung von Metallaggregaten (3) auf dem Metalloxidsubstrat (2),
b) Wachstum von Nanostrukturen (1) in der Gasphase auf dem Metalloxidsubstrat (2), das mit Metallaggregaten (3) bedeckt ist, wobei das Substrat im Vorhandensein von einem oder mehreren Vorläufergasen erhitzt wird und das Wachstum von Nanostrukturen (1) in der Gasphase durch die Metallaggregate (3) katalysiert wird,
**dadurch gekennzeichnet, dass**:
- das Metalloxidsubstrat (2) aus einem Substrat aus Glas oder Polymer oder anderem besteht, das durch einen dünnen Metalloxidfilm bedeckt ist, wobei der dünne Metalloxidfilm aus Oxid eines Metalls besteht, das einen Schmelzpunkt unter oder gleich 300 °C aufweist, wie SnO₂, ZnO, ITO oder In₂O₃;
- der Schritt der Bildung von Metallaggregaten a) einen Arbeitsgang der Reduzierung der Fläche des Metalloxidsubstrats mittels einer Behandlung mit reduzierendem Plasma umfasst, das die Bildung von Tröpfchen von Metallaggregaten (3) auf der Fläche des Metalloxidsubstrats (2) bewirkt,
- wobei die Schritte der Bildung von Metallaggregaten a) und des Wachstums von Nanostrukturen b) nacheinander in einem selben und einzigen Plasmareaktorraum (4) ausgeführt werden, wobei das Wachstum der Nanostrukturen durch CVD oder PECVD direkt auf den Metallaggregat-Tröpfchen (3) durchgeführt wird;
- das Metalloxidsubstrat (2) während der Schritte der Bildung der Metallaggregate a) und des Wachstums von Nanostrukturen b) auf eine Temperatur erhitzt wird, die höher oder gleich dem Schmelzpunkt des Metalls ist, aus dem das Metalloxid (2) hergestellt ist; und dadurch, dass:
- die Elemente, die die Nanostrukturen (1) bilden, von dem oder den während des Schritts b) des Wachstums von Nanostrukturen eingepressten Gas/en stammen, wobei die Elemente, die die Nanostrukturen (1) bilden, nichtmetallisch sind, und
- die Zusammensetzung der Nanostrukturen (1) sich von derjenigen des Metalloxidsubstrats (2) unterscheidet.

2. Verfahren zur Herstellung von Nanostrukturen (1) auf einem Metalloxidsubstrat (2) nach Anspruch 1, **dadurch gekennzeichnet, dass** das Metalloxid unter SnO₂, ZnO, ITO oder In₂O₃ ausgewählt wird.

3. Verfahren zur Herstellung von Nanostrukturen (1) auf einem Metalloxidsubstrat (2) nach einem der Ansprüche 1 oder 2, **dadurch gekennzeichnet, dass** das Metalloxidsubstrat (2) aus einem Substrat gebildet wird, das mit einer Metalloxidschicht bedeckt ist, wobei die Metalloxidschicht diskontinuierlich ist und Metalloxidmotive umfasst.

4. Verfahren zur Herstellung von Nanostrukturen (1) auf einem Metalloxidsubstrat (2) nach einem der Ansprüche 1 bis 3, **dadurch gekennzeichnet, dass** die Nanostrukturen (1) unter Si, Ge, SiGe, SiC, C oder SiN ausgewählt werden.

5. Verfahren zur Herstellung von Nanostrukturen (1) auf einem Metalloxidsubstrat (2) nach einem der Ansprüche 1 bis 4, **dadurch gekennzeichnet, dass** der Plasmareaktor (4) ein Reaktor für plasmagestützte chemische Gasphasenabscheidung (PECVD) ist, wobei das Vorläufergas, das während des Schrittes des Wachstums der Nanostrukturen (1) in der Gasphase b) verwendet wird, in einem Verdünnungsgas verdünnt wird, wobei das Verdünnungsgas durch Ätzung die Abscheidung amorpher Elemente außerhalb der Metallaggregate (3) begrenzt.

6. Verfahren zur Herstellung von Nanostrukturen (1) auf einem Metalloxidsubstrat (2) nach Anspruch 5, **dadurch gekennzeichnet, dass** das Verdünnungsgas Diwasserstoff (H₂) ist.

7. Verfahren zur Herstellung von Nanostrukturen (1) auf einem Metalloxidsubstrat (2) nach einem der Ansprüche 1 bis 6, **dadurch gekennzeichnet, dass** das reduzierende Plasma ein Wasserstoffplasma ist, wobei das Wasserstoffplasma-Behandlungsverfahren die folgenden Schritte umfasst:
- Einpressen von gasförmigem Wasserstoff (H₂) in den Plasmareaktorraum (4) und
- Erzeugen eines Plasmas im Plasmareaktorraum (4) während einer Dauer t, wobei der Durchmesser der Metallaggregat-Tröpfchen (3) unter anderem von der Dauer t abhängt.

8. Verfahren zur Herstellung von Nanostrukturen (1) auf einem Metalloxidsubstrat (2) nach einem der Ansprüche 1 bis 7, **dadurch gekennzeichnet, dass** der Plasmareaktor (4) ein Reaktor für hochfrequenzplasmagestützte chemische Gasphasenabscheidung (PECVD-RF) ist, wobei beim Arbeitsvorgang der Wasserstoffplasmabehandlung:
- der Wasserstoffdruck im Raum des Plasmareaktors (4) zwischen 180 mTorr und 1000 mTorr enthalten ist, was einer Dauer t der Plasmaerzeugung im Raum des Plasmareaktors (4) von ungefähr 3 Minuten entspricht,
- die Hochfrequenzleistungsdichte, die zum Erzeugen des Plasmas verwendet wird, zwischen 10 und 1000 mW/cm² enthalten ist.

9. Verfahren zur Herstellung von Nanostrukturen (1) auf einem Metalloxidsubstrat (2) nach einem der Ansprüche 1 bis 8, **dadurch gekennzeichnet, dass**:
- das Metalloxidsubstrat (2) mit Nanostrukturen (1) des Typs Nanodrähte aus kristallinem Element (5) bedeckt ist,
- das Verfahren ferner einen Schritt des Abscheidens eines Dünnfilms aus amorphem oder polykristallinem Element umfasst, während dem die Temperatur des Metalloxidsubstrats (2) in der Umgebung von 200 °C geregelt ist, wobei dasselbe Vorläufergas derart in den Plasmareaktor (4) eingepresst wird, dass die Bedeckung der Nanodrähte aus kristallinem Element (5) mit einem Dünnfilm aus amorphem oder polykristallinem Element (6) ermöglicht wird.

10. Verfahren nach Anspruch 9, **dadurch gekennzeichnet, dass** es nach dem Schritt des Abscheidens des Dünnfilms aus amorphem oder polykristallinem Element (6) einen weiteren Schritt des Abscheidens eines Dünnfilms aus amorphem oder polykristallinem Element (7) oder aus einem organischen Halbleiter-Dünnfilm umfasst.

11. Dünnfilmvorrichtung, **dadurch gekennzeichnet, dass** sie durch das Verfahren nach einem der Ansprüche 9 oder 10 erhalten wurde, wobei die Dünnfilmvorrichtung Folgendes umfasst:
- ein Metalloxidsubstrat (2), das mit Nanodrähten aus kristallinem Element (5) bedeckt ist, und
- einen Dünnfilm aus amorphem oder polykristallinem Element (6), das die Nanodrähte aus kristallinem Element (5) bedeckt.

12. Dünnfilmvorrichtung nach Anspruch 11, **dadurch gekennzeichnet, dass** sie einen Dünnfilm aus amorphem oder polykristallinem Element (7) oder einen organischen Halbleiterdünnfilm umfasst, der den Dünnfilm aus amorphem oder polykristallinem Element (6) bedeckt.

## Claims

1. Process of producing nanostructures (1) on a metal oxide substrate (2), comprising the steps of :
a) forming metal aggregates (3) on said metal oxide substrate (2),
b) vapour phase growing nanostructures (1) on said metal oxide substrate (2) covered with metal aggregates (3), said substrate being heated in the presence of one or more precursor gases, and the vapour phase growth of nanostructures (1) being catalyzed by the metal aggregates (3),
**characterized in that** :
- the metal oxide substrate (2) is composed of a glass or polymer substrate or other, covered with a thin-film metal oxide layer, the thin-film metal oxide layer being composed of the oxide of a metal having a melting point lower than or equal to 300°C, such as SnO₂, ZnO, ITO or In₂O₃ ;
- the step a) of forming metal aggregates comprises an operation of reducing the surface of the metal oxide substrate by means of reducing plasma treatment, causing the formation of metal aggregate droplets (3) on the surface of said metal oxide substrate (2),
- said steps of a) forming metal aggregates and b) growing nanostructures are carried out in series in a single and same plasma reactor chamber (4), the nanostructure growth, by CVD or PECVD, being made directly on the metal aggregate droplets (3) ;
- the metal oxide substrate (2) being heated to a temperature higher than or equal to the melting point of the metal composing the metal oxide (2) during said steps of a) forming metal aggregates and b) growing nanostructures; and **in that**
- the elements constituting the nanostructures (1) come from the precursor gases injected during the step b) of growing nanostructures, the elements constituting the nanostructures (1) being non-metallic elements, and
- the composition of said nanostructures (1) being different from that of the metal oxide substrate (2).

2. Process of producing nanostructures (1) on a metal oxide substrate (2) according to claim 1, **characterized in that** the metal oxide is chosen from SnO₂, ZnO, ITO or In₂O₃.

3. Process of producing nanostructures (1) on a metal oxide substrate (2) according to any one of claims 1 or 2, **characterized in that**, the metal oxide substrate (2) being formed of a substrate covered with a metal oxide layer, said metal oxide layer is discontinuous and comprises metal oxide patterns.

4. Process of producing nanostructures (1) on a metal oxide substrate (2) according to any one of claims 1 to 3, **characterized in that** the nanostructures (1) are chosen from Si, Ge, SiGe, SiC, C or SiN.

5. Process of producing nanostructures (1) on a metal oxide substrate (2) according to any one of claims 1 to 4, **characterized in that**, the plasma reactor (4) being a plasma-enhanced chemical vapour deposition (PECVD) reactor, the precursor gas used in the step b) of vapour phase growing the nanostructure (1) is diluted in a dilution gas, said dilution gas limiting by etching the deposition of amorphous elements outside the metal aggregates (3).

6. Process of producing nanostructures (1) on a metal oxide substrate (2) according to claim 5, **characterized in that** the dilution gas is dihydrogen (H₂).

7. Process of producing nanostructures (1) on a metal oxide substrate (2) according to any one of claims 1 to 6, **characterized in that** the reducing plasma is hydrogen plasma, wherein the process of hydrogen plasma treatment comprises the steps of:
- injecting gaseous hydrogen (H₂) in the chamber of the plasma reactor (4), and
- generating a plasma in the chamber of the plasma reactor (4) during a time duration t, the diameter of the metal aggregate droplets (3) depending, among other things, on said time duration t.

8. Process of producing nanostructures (1) on a metal oxide substrate (2) according to any one of claims 1 to 7, **characterized in that** the plasma reactor (4) is a radiofrequency plasma-enhanced chemical vapour deposition (PECVD-RF) reactor, wherein, during the operation of hydrogen plasma treatment:
- the pressure of hydrogen in the chamber of the plasma reactor (4) is comprised between 180 mTorr and 1000 mTorr, corresponding to a time duration t of plasma generation in the chamber of the plasma reactor (4) of about 3 min,
- the radiofrequency power density used to generate the plasma is comprised between 10 and 1000 mW/cm².

9. Process of producing nanostructures (1) on a metal oxide substrate (2) according to any one of claims 1 to 8, **characterized in that** :
- the metal oxide substrate (2) being covered with nanostructures (1) of the type crystalline element nanowires (5),
- the process comprises further a step of depositing an amorphous or polycrystalline element thin-film layer, during which the temperature of the metal oxide substrate (2) is controlled around 200°C, wherein the same precursor gas is injected into said plasma reactor (4), so as to permit the covering of the crystalline element nanowires (5) with an amorphous or polycrystalline element thin-film layer (6).

10. Process of producing nanostructures (1) on a metal oxide substrate (2) according to any one of claims 1 to 9, **characterized in that** it comprises, after the step of depositing the amorphous or polycrystalline element thin-film layer (6), another step of depositing an amorphous or polycrystalline element thin-film layer (7) or a semiconductor organic thin-film layer.

11. Thin-film device, **characterized in that** it has been obtained by the process as defined according to claim 9, said thin-film device comprising:
- a metal oxide substrate (2) covered with crystalline element nanowires (5), and
- an amorphous or polycrystalline element thin-film layer (6) covering said crystalline element nanowires (5).

12. Thin-film device according to claim 11, **characterized in that** it comprises an amorphous or polycrystalline element thin-film layer (7), or a semiconductor organic thin-film layer, covering said amorphous or polycrystalline element thin-film layer (6).
